(19) Europäisches Patentamt
European Patent Office
Office européen des brevets

(11) **EP 3 866 208 A2**

(12) **EUROPEAN PATENT APPLICATION**
published in accordance with Art. 153(4) EPC

(43) Date of publication:
**18.08.2021 Bulletin 2021/33**

(51) Int Cl.:
*H01L 31/0224* (2006.01)    *H01L 31/068* (2012.01)

(21) Application number: **19842367.5**

(22) Date of filing: **10.10.2019**

(86) International application number:
**PCT/ES2019/070690**

(87) International publication number:
**WO 2020/074764 (16.04.2020 Gazette 2020/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.10.2018 ES 201830987**

(71) Applicant: **Fundación CENER-CIEMAT**
**31621 Sarriguren (Navarra) (ES)**

(72) Inventors:
• **LAGUNAS ALONSO, Ana Rosa**
  **31621 Sarriguren, Navarra (ES)**
• **BENGOECHEA APEZTEGUÍA, Jaione**
  **31621 Sarriguren, Navarra (ES)**
• **ZUGASTI ROSENDE, Eugenia**
  **31621 Sarriguren, Navarra (ES)**
• **RODRÍGUEZ HENCHE, María Jesús**
  **31621 Sarriguren, Navarra (ES)**

(74) Representative: **ABG Intellectual Property Law, S.L.**
**Avenida de Burgos, 16D**
**Edificio Euromor**
**28036 Madrid (ES)**

(54) **PHOTOVOLTAIC SOLAR CELL AND METHOD FOR PRODUCING SAME**

(57)    The present invention relates to a photovoltaic solar cell and a manufacturing method, comprising a front electrode (2) which is arranged on a silicon substrate (1) and which front electrode (2) has at least fingers (4) and busbars (5), which are formed by a single material consisting exclusively of a metal silicide, the electrode being obtained by depositing a metal on the silicon substrate (1) and applying thermal treatment to induce a reaction between the metal and the silicon, such that the photovoltaic solar cell has a power loss similar to the loss of conventional cells having a silver electrode or an additional coat of conductive material.

FIG. 1

EP 3 866 208 A2

**Description**

Field of the Art

The present invention relates to photovoltaic solar cells, and more specifically to a silicon photovoltaic solar cell and its manufacturing process, said cell having a front electrode formed by a single material, which is a metal silicide, obtained by thermal treatment, preventing the need to coat said front electrode with additional conductive materials, and particularly preventing the use of silver which increases the cost of the cell.

State of the Art

In recent years, the rise of renewable energies is becoming increasingly important for mitigating fossil fuel consumption. Photovoltaic solar energy is one of the most promising renewable energies. One of the main objectives of photovoltaic solar energy development lies in reducing solar energy production costs, for example, by reducing the photovoltaic module manufacturing cost.

Photovoltaic modules are made up of photovoltaic solar cells which transform light energy from the sun into electric energy. A standard photovoltaic solar cell is made up of a front electrode, a silicon substrate acting as an active layer, and a rear electrode, the active layer being arranged between both electrodes. The front electrode has conductive branches channeling electricity out of the cell, said branches consisting of a conductive grid or mesh, also termed "fingers", and busbars. The grid is formed by fingers that are thinner than the busbars and their function is to collect the electric energy obtained in the cell in order to send it to the busbars, in which the contacts between adjacent cells are welded.

The front electrode is generally formed by silver that is deposited by means of screen printing and proves to be a particularly suitable material for manufacturing solar cells due to its low resistivity, good thermal stability, and high compatibility with silicon processes. Another alternative to this process is the use of a metal silicide as an intermediate material between the silicon substrate and an additional conductive material, used for achieving conductivity conditions of the front electrode that are required for extracting the current, minimizing resistive losses. The following documents mention the use of metal silicides in manufacturing photovoltaic solar cells, and in which additional layers of conductive material are used to improve the conductivity of the front electrode. EP2428997A2, US2014096823A1, WO2013076267A1, US2010071751A1, US2010037941A1.

The use of a conductive material such as silver, or of a silicide on which an additional conductive material is deposited, as well as the method of deposition thereof, considerably increases the manufacturing cost of photovoltaic solar cells. Today, silver has a 13% impact on the cost of the cell, without taking into account the price of silicon. Accordingly, there is a need for an alternative solution for obtaining photovoltaic solar cells which prevents the use of silver or complex manufacturing processes, maintaining suitable energy efficiency.

Object of the Invention

The present invention proposes a photovoltaic solar cell having a front electrode, its manufacturing method, and a photovoltaic module formed by photovoltaic solar cells, wherein the front electrode of the proposed solar cell is formed by a single material which does not require using a silver electrode but which, however, allows obtaining an energy efficiency similar to that of conventional solar cells using said silver or other more complex deposition processes.

The proposed photovoltaic solar cell comprises the front electrode which is arranged on a silicon substrate and has at least fingers for channeling the electric energy generated in the active material and sending it out of the cell. Preferably, the front electrode has fingers and busbars for channeling the electric energy generated in the active material and sending it out of the cell.

According to the invention, the front electrode of the solar cell is formed by a single material consisting exclusively of a metal silicide, without including any additional layer of conductive material.

The manufacturing method for manufacturing the front electrode of the photovoltaic solar cell object of the present invention comprises arranging a metal on a silicon substrate and applying thermal treatment to induce a reaction between the metal and the silicon, thereby obtaining the front electrode which is formed by the single material consisting exclusively of metal silicide.

The use of metal silicide as the single material to form the front electrode of the photovoltaic solar cell thereby prevents the use of silver as well as any other additional process for forming the front electrode, thereby reducing the cost of the cell.

As an example, in order for the photovoltaic solar cell to have a power loss similar to that of conventional cells, the fingers have a width of about 5 $\mu$m and a minimum separation between fingers of at least 0.2 mm, and the front electrode has at least 27 busbars.

If fingers with widths less than 5 $\mu$m can be manufactured, the rest of the optimum parameters will be derived from the equations described below.

Even more preferably, the fingers have a width comprised between 5 and 30 $\mu$m and a minimum separation between fingers of between 0.2 and 1.1 mm, and the number of busbars is comprised between 27 and 34.

According to an embodiment of the invention, the fingers have a width of 5 $\mu$m and a minimum separation between fingers of 0.2 mm, and the front electrode has 27 busbars, wherein each busbar has a width of 148 $\mu$m and a maximum separation between busbars of 5.6 mm.

According to another embodiment of the invention, the fingers have a width of 30 $\mu$m and a minimum separation between fingers of 1.1 mm, and the front electrode has 34 busbars, wherein each busbar has a width of 118 $\mu$m and a maximum separation between busbars of 4.5 mm.

Accordingly, a solar cell with a front electrode which does not require depositing an additional layer to improve its electrical conductivity is thereby obtained. Likewise, the use of silver is entirely avoided.

This technology is compatible with the multi-busbar cell connection technology, for which optimizing the parameters of the fingers would be necessary and busbars would not be required. In the case of SmartWire multi-busbar technology and other technologies using a similar concept, the busbars are replaced with 18 microwires.

Likewise, it must be pointed out that the rear electrode can also be manufactured by means of the materials and methods described in the present invention.

Description of the Drawings

Figure 1 shows a perspective view of a photovoltaic solar cell with a silicon wafer which has on its upper face a front electrode and on its lower face a rear electrode.

Figure 2 shows a graph with the power loss curves of three photovoltaic solar cells according to the invention with fingers having a width of 5 $\mu$m, 30 $\mu$m, and 60 $\mu$m.

Detailed Description of the Invention

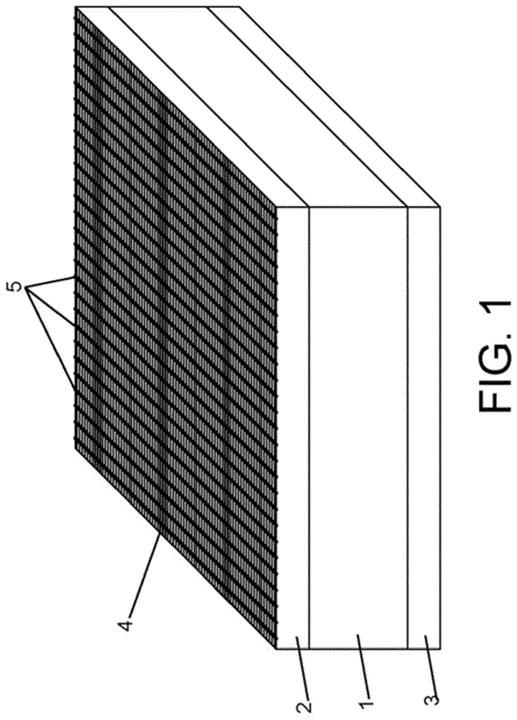

Figure 1 shows the basic configuration of a silicon photovoltaic solar cell which is formed by a silicon substrate (1), a front electrode (2) which is arranged on one of the faces of the silicon substrate (1) receiving solar radiation, and a rear electrode (3) which is arranged on the face of the silicon substrate (1) opposite the face on which the front electrode (2) is arranged.

The solar radiation striking the surface on which the front electrode (2) is arranged is thereby absorbed by the active material, with electric charge carriers being generated.

The front electrode (2) has conductive fingers (4) forming a grid or mesh and busbars (5) channeling electricity out of the photovoltaic solar cell. The fingers (4) collect the energy generated in the active material of the front electrode (2) and channel it to the busbars (5), which extract said energy out of the cell.

According to the invention, the front electrode (2) is formed by a single material consisting exclusively of a metal silicide.

The metal silicide is obtained by arranging a thin layer of metal on the silicon substrate (1) and applying thermal treatment to induce a reaction between the metal and the silicon to give rise to the metal silicide.

The metal which is arranged on the silicon substrate (1) can be titanium, cobalt, or nickel.

In order to obtain a power loss below 8%, and therefore in order for the silicon photovoltaic solar cell to have an efficiency similar to that of conventional cells, the fingers (4) of the conductive grid of the front electrode (2) must have an approximate width of 5 $\mu$m and a separation between fingers (4) greater than 0.2 mm, and the front electrode (2) must have at least 27 busbars (5).

The equation shown below is used for calculating the power loss of the cell, shade loss and electrical losses being taken into account in said equation:

$$P_{loss} = \frac{J_{MPP}}{V_{MPP}}(1 - P_S)R_{SeriesTotal} \cdot Area \qquad [1]$$

where Ps refers to the fraction of total shade and is calculated according to the following equation:

$$P_S = (1 - t_b)\frac{w_b}{2a} + \frac{(1 - t_f)w_f(l_f + (w_b/2) \cdot t_b)}{s \cdot a} \qquad [2]$$

and where $R_{SeriesTotal}$ refers to the total series resistance of all the components of the cell and is calculated according to the following equation:

$$R_{SeriesTotal} = \frac{\sum R_{Components}}{4n \cdot N}$$  [3]

The components of the cell and the equation for calculating the resistance of each of them are defined below:

| Component | Equation |
|---|---|
| Resistance of the emitter | $R_{emitter} = \dfrac{n \cdot s^2}{3L} \dfrac{R_e}{(\frac{L}{N} - w_{bus})}$ |
| Resistance of the fingers | $R_{finger} = \dfrac{n \cdot s}{3L} \dfrac{\rho_{metal}}{w_f \cdot h_f} (\frac{L}{N} - w_{bus})$ |
| Resistance of the busbars | $R_{bus} = \dfrac{\rho_{metal}}{3n} \dfrac{L}{w_{bus} \cdot h_{bus}}$ |
| Resistance of the front contact | $R_{FrontContact} = \dfrac{4NnsR_{FrontPaste}}{L(w_f \cdot L + Nw_{bus} \cdot (s - w_f))}$ |

The contribution of the silicon substrate (1) and of the rear electrode (3) to the resistance of the element channeling the current is considered irrelevant due to the low value thereof, and therefore they have not been taken into consideration.

The following table indicates all the parameters included in the preceding equations.

| Symbol | Description | Unit |
|---|---|---|
| $J_{MPP}$ | Total current density at maximum power point per cell | A/cm$^2$ |
| $V_{MPP}$ | Cell voltage at maximum power point | V |
| $t_b$ | Effective busbar transparency factor | - |
| $t_f$ | Effective finger transparency factor | - |
| a | Sum of $w_{bus/2}$ and length of fingers | cm |
| $l_f$ | Length of fingers | cm |
| $w_{f,bus}$ | Width of fingers or busbars | cm |
| n | Number of welding points | - |
| s | Separation between fingers | cm |
| $R_e$ | Resistance of the emitter layer | Ω/square |
| L | Substrate size | cm |
| N | Number of busbars | - |
| $\rho_{metal}$ | Resistivity of the metal grid formed by fingers and busbars | Ω·cm |
| $h_{f,bus}$ | Height of fingers or busbars | cm |
| $R_{FrontPaste}$ | Specific resistivity of the semiconductor- | Ω·cm$^2$ |
| | metal contact | |

The power loss of the cell $P_{loss}$ is calculated using equations [1] to [3] indicated above. As can be seen from those equations, many parameters contribute to power loss. Accordingly, for some parameters, values representative of the actual state of technology, which are indicated below, have been taken:

- $R_e$: 100 $\Omega/\square$

- Cell size: 156 mm x 156 mm

- $R_{FrontPaste}$ : $10^{-7}$ $\Omega \cdot m^2$

- $J_{MPP}$: 34 mA/cm$^2$

- $V_{MPP}$: 0.52 V

- n=40

- Resistance of the metal silicide layer: 0.3 $\Omega/\square$. (Assuming a thickness of 500 nm and a material resistivity of 0.5 x $10^{-5}$ $\Omega \cdot cm$)

- tb, tf=0

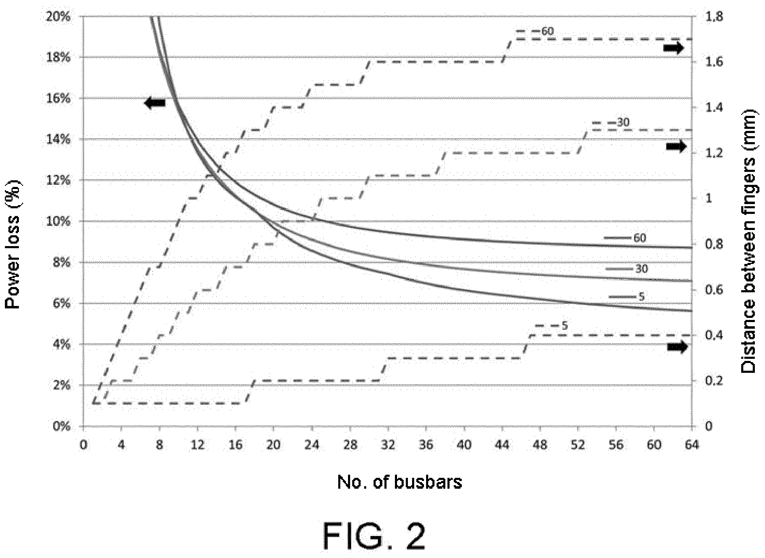

Figure 2 shows a graph in which the power loss of the photovoltaic solar cell is calculated for different designs of the front electrode (2). Said graph shows power loss calculation for three specific widths of fingers (4) of the conductive grid (5 $\mu$m, 30 $\mu$m, 60 $\mu$m) depending on the number of busbars (5) and the distance between fingers (4).

It is observed in said graph that in order to obtain a power loss below 8%, which is a loss similar to the loss of conventional cells, a front electrode (2) with fingers (4) having a width of 60 $\mu$m is not suitable. It is also observed from said graph that a power loss below 8% is obtained for fingers having a width of 30 $\mu$m with at least 34 busbars and a distance between fingers of at least 1.1 mm, and also for fingers having a width of 5 $\mu$m with at least 27 busbars and a distance between fingers of at least 0.2 mm.

A table with the parameters of the front electrode (2) for obtaining a power loss below 8% according to the two widths of the fingers (4) of 30 $\mu$m and 5 $\mu$m is shown below.

| Finger width ($\mu$m) | Distance between fingers (mm) | Number of busbars | Busbar width ($\mu$m) | Distance between busbars (mm) |
|---|---|---|---|---|
| 30 | >1.1 | >34 | <118 | <4.5 |
| 5 | >0.2 | >27 | <148 | <5.6 |

The metal silicide is obtained by arranging a thin layer of metal on the silicon substrate (1) and applying thermal treatment to induce a reaction between the metal and the silicon to give rise to the metal silicide.

The formation of metal silicide is obtained according to the following steps:

- Cleaning the silicon substrate (1) to eliminate possible contaminants.
- Depositing the thin layer of metal on the silicon substrate (1) .
- Applying thermal treatment by means of a heat source to obtain metal silicide, where the thermal treatment can be, among other possible treatments, furnace annealing, rapid thermal annealing, laser annealing, or a combination thereof.

To obtain metal silicide, the silicon substrate (1) with the layer of metal must be heated at a temperature of about 700°C - 800°C for a few seconds, where it is not recommendable for the temperature to exceed 900°C to prevent agglomeration effects which cause an increase in the electrical resistance of the obtained material. The heating process for producing metal silicide can be performed in one or two steps.

The following 4 fundamental steps are performed for manufacturing the photovoltaic solar cell:

- Conditioning the surface of the silicon substrate (1) and forming a p-n bond
- Performing passivation on the surface of the silicon substrate (1) and depositing an anti-reflective coating.
- Forming the front electrode (2).

- Forming the rear electrode (3).

Described below is the process for obtaining the metal silicide according to two thermal treatment types: a laser process and a furnace or rapid thermal annealing process.

The formation of metal silicide by means of laser comprises the following basic steps:

I. Eliminating surface damage, texturing and cleaning the upper face of the silicon wafer (1).
II. Obtaining the emitter.
III. Eliminating PSG (phosphor-silicate glass) from the diffusion process.
IV. Depositing the thin layer of metal.
V. Forming the metal silicide by laser treatment.
VI. Eliminating the metal part that does not react with silicon.
VII. Cleaning the silicon surface.
VIII. Passivating the surface and depositing an anti-reflective coating.
IX. Making the rear contact (3).
X. Optionally making openings in the anti-reflective coating by means of laser to allow welding the busbars (5) of the front electrode (3) with conductive fingers.

If a selective emitter is required to prevent current bypass, this may be made by means of a laser step introduced in the previous process sequence, after step II. Furthermore, the laser-induced silicide formation step would require alignment with the previously formed selective emitter. In this process sequence, the emitter may also be made of a doped polysilicon material, in which case, passivation would not be required. The process sequence will be very similar to that described above.

The formation of metal silicide by means of a furnace or rapid thermal annealing process comprises the following basic steps:

i. Eliminating surface damage, texturing and cleaning the upper face of the silicon wafer (1).
ii. Obtaining the emitter.
iii. Depositing the passivating anti-reflective layer.
iv. Obtaining grooves in the passivating anti-reflective layer by means of laser.
v. Cleaning the grooves made by means of laser.
vi. Depositing the thin layer of metal.
vii. Forming metal silicide in a furnace or by means of a rapid thermal annealing process.
viii. Eliminating the metal part that does not react with silicon.
ix. Making the rear contact (3).

The thin layer of metal can be selectively deposited in the grooves by means of metal printing (step vi).

## Claims

1. A photovoltaic solar cell comprising a front electrode (2), a rear electrode (3), and a silicon substrate (1) arranged between the front electrode (2) and the rear electrode (3), wherein
the front electrode (2) comprises a plurality of conductive fingers (4) and a plurality of busbars (5) for channeling the generated electric current,
**characterized in that**
the front electrode (2) is formed by a single material consisting exclusively of metal silicide,
the conductive fingers (4) are separated from one another by a distance s, with s > 0, and
the conductive fingers (4) have a width $w_f$ equal to or less than 30 $\mu$m.

2. The photovoltaic solar cell according to the preceding claim, **characterized in that** the metal of the metal silicide is selected from the group consisting of titanium, cobalt, and nickel.

3. The photovoltaic solar cell according to any of the preceding claims, **characterized in that** the distance s between the conductive fingers (4) of the front electrode (2) is at least 0.2 mm, and the number N of busbars (5) is at least 27.

4. The photovoltaic solar cell according to any of the preceding claims, **characterized in that** the conductive fingers (4) of the front electrode (2) have a width wf of 5 $\mu$m.

5. The photovoltaic solar cell according to any of claims 1 to 3, **characterized in that** the conductive fingers (4) of the front electrode (2) have a width wf of 30 $\mu$m.

6. The photovoltaic solar cell according to claim 4, **characterized in that** the distance between conductive fingers (4) is s $\geq$ 0.2 mm, the number of busbars (5) is N $\geq$ 27, and wherein each busbar (5) has a width $w_{bus} \leq 148$ $\mu$m and the distance between busbars (5) is less than or equal to 5.6 mm.

7. The photovoltaic solar cell according to claim 5, **characterized in that** the distance between conductive fingers (4) is s $\geq$ 1.1 mm, the number of busbars (5) is N $\geq$ 34, and wherein each busbar (5) has a width $w_{bus} \leq 118$ $\mu$m and the distance between busbars (5) is less than or equal to 4.5 mm.

8. The photovoltaic solar cell according to any of the preceding claims, **characterized in that** the fingers (4) have parameters compatible with the SmartWire-type multi-busbar cell connection technology.

9. A photovoltaic module comprising a photovoltaic solar cell according to any of claims 1 to 8.

10. A manufacturing method for manufacturing a photovoltaic solar cell according to claims 1 to 8, **characterized in that** it comprises the steps of:

   - conditioning the surface of the silicon substrate (1) and forming a p-n bond in the silicon substrate (1),
   - performing passivation on the surface of the silicon substrate (1) and depositing an anti-reflective coating on the surface of the silicon substrate (1),
   - forming the front electrode (2),
   - forming the rear electrode (3);

   **characterized in that** the step of forming the front electrode (2) comprises the steps of:

   - cleaning the silicon substrate (1),
   - arranging a thin layer of metal on the surface of the silicon substrate (1), and
   - applying heat treatment to induce a reaction between the metal and the silicon of the silicon substrate (1).

11. The manufacturing method for manufacturing a photovoltaic solar cell according to claim 10, **characterized in that** it additionally comprises the steps of:

   - eliminating surface damage, texturing and cleaning the upper face of the silicon wafer (1),
   - obtaining the emitter, and
   - forming the metal silicide by laser treatment.

12. The manufacturing method for manufacturing a photovoltaic solar cell according to claim 11, **characterized in that** it additionally comprises the step of making openings in the anti-reflective coating by means of laser to allow welding the busbars (5) of the front electrode (3) with conductive fingers.

13. The manufacturing method for manufacturing a photovoltaic solar cell according to claim 10, **characterized in that** it additionally comprises the steps of:

   - eliminating surface damage, texturing and cleaning the upper face of the silicon wafer (1),
   - obtaining the emitter,
   - depositing the passivating anti-reflective layer,
   - obtaining grooves in the passivating anti-reflective layer by means of laser, and
   - forming metal silicide in a furnace or by means of a rapid thermal annealing process.

14. The manufacturing method for manufacturing a photovoltaic solar cell according to claim 13, **characterized in that** the step of depositing the layer of metal is performed by means of metal printing.

15. The manufacturing method for manufacturing a photovoltaic solar cell according to any of claims 10 to 14, **characterized in that** the step of applying thermal treatment is performed at an approximate temperature of less than 900°C, preferably between 700°C and 800°C.

FIG. 1

EP 3 866 208 A2

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2428997 A2
- US 2014096823 A1
- WO 2013076267 A1
- US 2010071751 A1
- US 2010037941 A1